# EUROPEAN PATENT SPECIFICATION

(11) **EP 2 328 265 B1**
(45) Date of publication and mention of the grant of the patent: **04.09.2019**
(21) Application number: 09814318.3
(22) Date of filing: 17.09.2009
(51) Int. Cl.: H02M 7/48, H01L 25/07, H01L 25/18, H05K 7/14, H05K 3/28, H05K 5/06

(54) **INVERTER DEVICE**
UMRICHTERVORRICHTUNG
DISPOSITIF INVERSEUR

(30) Priority: 18.09.2008 JP 2008239038
(43) Date of publication of application: 01.06.2011
(73) Proprietor: Mitsubishi Heavy Industries, Ltd., Tokyo 108-8215 (JP)
(72) Inventor: TESHIMA, Kazunori, Nagoya-shi Aichi 453-8515 (JP); TOYAMA, Koji, Hiroshima-shi Hiroshima 733-8553 (JP); NAKANO, Koji, Nagoya-shi Aichi 453-8515 (JP); SATO, Hidetaka, Kiyosu-shi Aichi 452-8561 (JP)
(74) Representative: Henkel, Breuer & Partner
(86) International application number: PCT/JP2009/004694
(87) International publication number: WO 2010/032473

(56) References cited:
- JP-A- H10 270 609
- JP-A- 2003 153 552
- JP-A- 2004 104 860
- JP-A- 2006 316 754
- JP-A- 2007 123 644
- JP-A- 2007 123 644
- JP-A- 2007 315 269
- JP-A- 2008 061 375
- US-B1- 6 215 679

## Description

### Technical Field

The present invention relates to an inverter device, and, for example, relates to an inverter device suitable for constituting an electric compressor integrally with a compression mechanism and an electric motor that drives the compressor mechanism.

### Background Art

An on-vehicle air conditioner in an electric car or a fuel-cell car without an engine includes a compressor including an electric motor as a power supply for compressing and circulating a refrigerant. The compressor includes an inverter device that converts DC power supplied from a battery that is an on-vehicle power supply into three-phase AC power and supplies the AC power to the electric motor. From a desire for space saving, there is an integral electric compressor including an inverter device incorporated into one housing together with a compression mechanism and an electric motor.

To the inverter device, a smoothing capacitor for preventing changes in DC power is electrically connected in parallel.

For mounting of a smoothing capacitor, for example, Patent Document 1 proposes that positive and negative laminated input conductor plates connected to input terminals of a switching module including a radiating base substrate, an insulating substrate, and a semiconductor device are bent to three-dimensionally place a smoothing capacitor and a control circuit board with respect to the switching module.

Patent Document 2 discloses an inverter device in which a smoothing capacitor for preventing changes in DC power is placed above a power semiconductor device in a module case.

### Citation list

### Patent Document

Patent Document 1: Japanese Patent Laid-Open No. 9-308265 (FIG. 1)
Patent Document 2: Japanese Patent Laid-Open No. 2004-335625 (FIG. 1)

JP 2007 123644 A discloses a power semiconductor device including a semiconductor device for performing power conversion from DC to AC or from AC to DC, a smoothing capacitor for smoothing a DC power source output and a control circuit for controlling the power conversion of the semiconductor device. In the power semiconductor device, the smoothing capacitor is a ceramic capacitor, the semiconductor device and the smoothing capacitor are electrically bonded to a Cu pattern (wiring) on a metal base plate having a heat dissipation function. A protection mechanism comprising an element which is fused and disconnected when an overcurrent flows to a circuit of the wiring, and electrodes provided in both terminals of the element and bonded to the wiring, is bonded to the wiring with a bonding member and disposed in series with the smoothing capacitor.

US 6 215 679 B1 discloses an alternator being equipped with a switching power module having a resin case housing switching elements and a driving circuit section, a smoothing capacitor for smoothing a direct current output supplied to the switching elements, a control circuit section for outputting a control signal to the driving circuit section and a cooling member; a ceramic capacitor is used as the smoothing capacitor; a smoothing capacitor board for mounting the smoothing capacitor is disposed between an insulating board mounting with the switching elements and a driving circuit board mounting with the driving circuit section.

US 6 704 202 B1 discloses a compact power controller for driving a compressor motor of a refrigerating system.

### Disclosure of the Invention

### Problems to be solved by the Invention

Patent Document 1 can reduce a mounting area of an inverter device to effectively use space. However, the inverter device in Patent Document 1 has a structure in which one end of the cylindrical smoothing capacitor is fixed to the control circuit board provided vertically to the switching module. Thus, if the inverter device in Patent Document 1 is mounted in a car and vibrated, the control circuit board may be horizontally bent and displaced to cause the smoothing capacitor to oscillate around a fixed end (on the control circuit board side), which may provide insufficient durability.

In the inverter device in Patent Document 2, the control circuit board is placed in parallel with a bottom floor of the module case, and thus higher durability against vibration than that in Patent Document 1 is provided. However, in the inverter device in Patent Document 2, a terminal of the smoothing capacitor is fastened by a screw to the module case to fix the smoothing capacitor, which may also provide insufficient durability under a severe vibration condition of a car. In Patent Document 2, a fixed base protruding in a cantilevered manner in the module case supports an end of the smoothing capacitor from below, but the fixed base increases a height of the inverter device, which prevents a reduction in size, particularly, height of the inverter device.

In view of the above-described background, the present invention has an object to provide an inverter device that is small in size and has durability against long-term use with vibration.

### Solution to Problem

According to the present invention, there is provided an inverter device as set out in independent claim 1. Advantageous developments are defined in the dependent claims.

An inverter device of the present invention is based on modularization for a size reduction. Specifically, the inverter device of the present invention includes two substrates: a power substrate that converts DC power supplied from a high voltage power supply into AC power and applies the AC power to an electric motor; and a control substrate that controls the application of the AC power to the electric motor. The power substrate is placed at a bottom of a box-shaped module case, and the control substrate forms a lid of an opening in the module case, and thus the inverter device of the present invention is modularized. In the inverter device of the present invention, the smoothing capacitor is provided on the power substrate, a resin mold layer is filled into the module case from the power substrate to a position covering the smoothing capacitor to fix the smoothing capacitor in the module case. The smoothing capacitor is fixed in the module case by the resin mold layer, which provides higher durability against vibration than that by conventional fastening with a screw.

In the present invention, a film capacitor can be used as a smoothing capacitor. Generally, a film capacitor covered with resin is distributed, but in the present invention, a film capacitor element can be used without a protective layer of resin. This can reduce a thickness of the smoothing capacitor, and thus reduce a height of the inverter device.

The smoothing capacitor comprised of the film capacitor includes a laminated body and an electrode, and is electrically connected to the power substrate via the electrode. However, in the present invention, the power substrate and the film capacitor may be electrically connected via an electrode of the film capacitor and a lead wire connected to the electrode.

A conductive pattern electrically connected to the electrode of the smoothing capacitor needs to be placed on the power substrate correspondingly to the electrode of the smoothing capacitor. However, this limits circuit design of the power substrate. On the other hand, the conductive pattern of the power substrate and the electrode of the smoothing capacitor are connected via the lead wire, and thus the conductive pattern can be provided in any position, thereby increasing flexibility in circuit design of the power substrate.

When the conductive pattern of the power substrate and the electrode of the smoothing capacitor are connected via the lead wire, a first resin mold layer is formed with the conductive pattern of the power substrate and the lead wire being connected. At the time when the first resin mold layer is formed, a tip of the lead wire connected to the electrode of the smoothing capacitor is exposed from an upper surface of the first resin mold layer. Then, with the tip of the lead wire and the electrode of the capacitor being connected, a second resin mold layer may be formed to cover the smoothing capacitor.

### Advantageous effects of Invention

According to the present invention, the power substrate and the control substrate are modularized, thereby reducing a size of the inverter device. In the inverter device of the present invention, the smoothing capacitor is fixed in the module case by the resin mold layer, which provides higher durability against vibration than that by conventional fastening with a screw.

### Brief Description of Drawings

FIG. 1 is a partial sectional view of an inverter device according to a first embodiment.
FIG. 2 is a schematic view showing a circuit configuration of a power substrate according to the first embodiment.
FIGS. 3A and 3B are views showing a capacitor according to the first embodiment.
FIGS. 4A and 4B are partial sectional views of an inverter device according to a second embodiment.
FIG. 5 is a view showing essential parts of an inverter device according to a third embodiment.
FIG. 6 is another view showing essential parts of the inverter device according to the third embodiment.

### Description of Embodiments

### <First embodiment>

Hereinafter the present invention will be described in detail based on embodiments shown in the accompanying drawings.

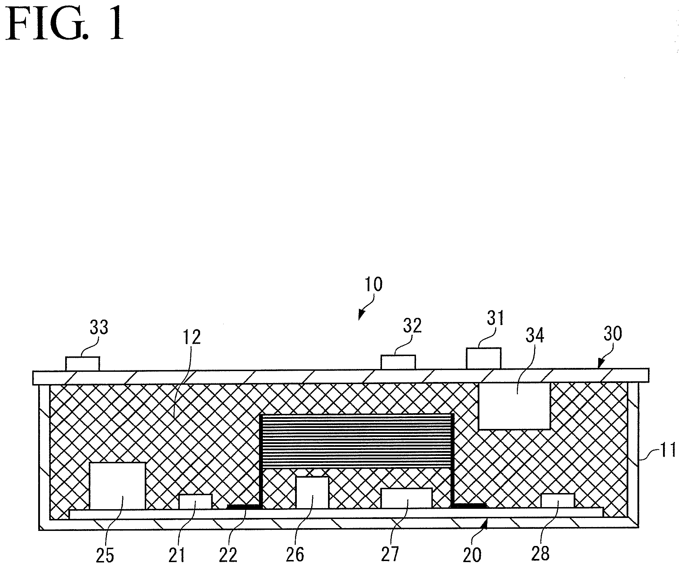

An embodiment of an inverter device according to the present invention will be described with reference to FIGS. 1 to 3.

An inverter device 10 is mounted in an electric vehicle such as an electric car that uses an electric motor as a drive source of the vehicle, or a hybrid car that uses an engine that is an internal combustion engine and an electric motor as a drive source of the vehicle, and is an electric power conversion device that converts DC power supplied from a battery that is an on-vehicle power supply into three-phase AC power and supplies the AC power to the electric motor.

The inverter device 10 includes a module case 11, a power substrate 20 provided at a bottom of the module case 11, and a control substrate 30 that closes an opening in the module case 11.

The power substrate 20 coverts DC power supplied from a high voltage power supply 40 into AC power, applies the AC power to an electric motor 50 according to control by the control substrate 30 to rotationally drive the electric motor 50.

The control substrate 30 controls the application of the AC power converted by the power substrate 20 to the electric motor 50.

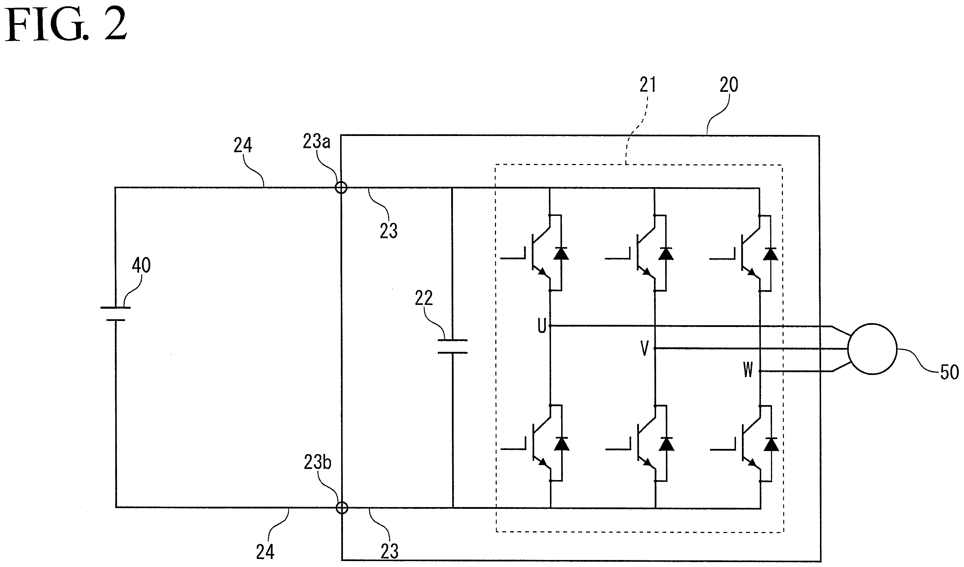

FIG. 2 is a schematic view showing a circuit configuration of the power substrate 20. Electric power of high voltage, for example, 300 V is supplied from the high voltage power supply 40 to the power substrate 20. A switching element 21 comprised of a plurality of IGBTs and a gate circuit (not shown) are mounted on the power substrate 20.

A microcomputer that controls an operation of the switching element 21 is provided on the control substrate 30. When a control signal of the microcomputer is transmitted from the control substrate 30 to the power substrate 20 to drive the gate circuit, and input to the switching element 21, the switching element 21 is operated. Thus, DC power of high voltage supplied from the high voltage power supply 40 is converted into a three-phase AC and applied to the electric motor 50 to rotationally drive the electric motor 50. The electric motor 50 is an alternator such as an induction motor or a synchronous motor.

A smoothing capacitor (hereinafter simply referred to as a capacitor) 22 that smoothens pulsing of the DC power is electrically connected to the power substrate 20 in parallel. A snubber capacitor for removing noise in a high frequency band may be provided on the power substrate 20, but may be omitted because the capacitor 22 is provided on the power substrate 20 to also remove the noise in the high frequency band.

In the circuit configuration described above, the electric power is supplied from the high voltage power supply 40 to the power substrate 20 via an input/output terminal 23, and the input/output terminal 23 is comprised of pin-shaped PN terminals 23a and 23b mounted on the power substrate 20.

To the PN terminals 23a and 23b, for example, a busbar (wire for applying a voltage to the power substrate 20) 24 is connected from a side of the high voltage power supply for electrical conduction.

As shown in FIG. 1, the inverter device 10 includes the box-shaped module case 11 having an opening in an upper portion and a rectangular plane. The module case 11 is produced, for example, by injection molding of resin, and a wire comprised of a busbar or the like, a terminal, and the like that are not shown are embedded in a side wall and a bottom floor.

The power substrate 20 is placed on the bottom floor in the module case 11. On the power substrate 20, other electronic components 25 to 28 are provided in addition to the capacitor 22. In this example, the power substrate 20 is placed on the bottom floor, but a configuration in which the capacitor 22 and the other electronic components 25 to 28 are directly provided on the bottom floor of the module case 11 and the bottom floor functions as the power substrate 20 is covered by the present invention.

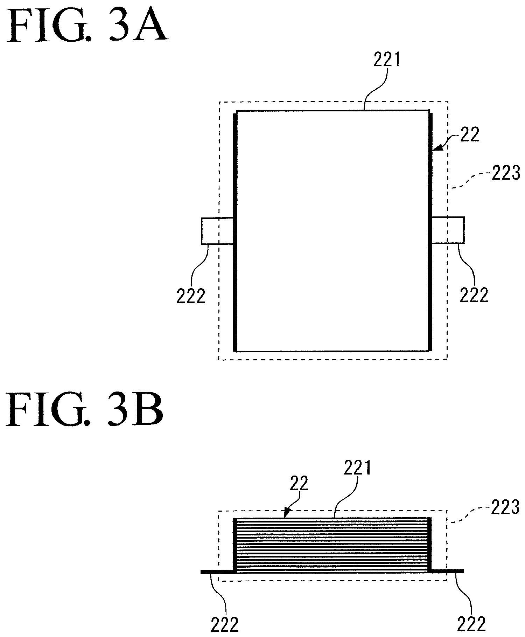

The capacitor 22 that is the film capacitor includes a laminated body 221 and an electrode 222 as shown in FIG. 3. The rectangular parallelepiped laminated body 221 is configured, for example, by laminating resin films with aluminum deposited on surfaces thereof in a comb shape. The electrode 222 is placed on each of opposite sides in a width direction of the laminated body 221. The electrode 222 is electrically connected to a conductive pattern (not shown) provided on the power substrate 20.

The capacitor 22 is covered with a resin layer 223 around the laminated body 221 and at a part of each electrode 222 as a general sales configuration as shown by the dotted line in FIG. 3. This is because the laminated body 221 is formed of a thin resin film, and without being covered with resin or the like, the resin film may be delaminated or damaged to impair the function of the capacitor 22. Generally, the resin layer 223 has a thickness of about 1 to 2 mm, and without the resin layer 223, the height of the inverter device 10 can be reduced for the thickness. In the present invention, a capacitor 22 covered with a resin layer 223 or a film capacitor element 22 that is not covered with a resin layer 223 may be used. In the present invention, even if the resin layer 223 is provided, the laminated body 221 may be partially covered as shown in FIG. 3 rather than entirely covered.

As shown in FIG. 1, the control substrate 30 is placed at the upper end of the side wall of the module case 11 to close the upper opening in the module case 11. As shown in FIG. 1, a CPU (Central Processing Unit) 31 that comprises the microcomputer, and other electronic components 32 and 33 are provided on an upper surface of the control substrate 30. An electronic component 34 is provided on a lower surface of the control substrate 30.

As shown in FIG. 1, a region surrounded by the module case 11 and the control substrate 30 in the inverter device 10 is filled with a resin mold layer 12 formed of epoxy resin or other resin. The resin mold layer 12 can be formed as described below. The power substrate 20 is placed in a predetermined position on the bottom floor of the module case 11, then a resin composition before cured is poured into the module case 11, and then the resin composition is cured with the control substrate 30 being placed on the predetermined position. The resin mold layer 12 firmly fixes the power substrate 20 to the module case 11, and further fixes the capacitor 22 to the power substrate 20.

The above-described inverter device 10 provides advantages described below.

In the inverter device 10, the power substrate 20 is provided at the bottom of the module case 11, the control substrate 30 functions as the lid of the module case 11, and the capacitor 22 is housed in the module case 11. This can reduce the size, particularly, the height of the inverter device 10.

The capacitor 22 provided on the power substrate 20 is covered with the resin mold layer 12 and fixed in the module case 11. Thus, even if the inverter device 10 is mounted in a car and used for a long period, the capacitor 22 is firmly fixed on the power substrate 20 by the resin mold layer 12 filled in the module case 11, and thus the capacitor 22 is reliably connected to the power substrate 20.

In the inverter device 10, the capacitor 22 is placed immediately above the switching element 21 of the power substrate 20, thereby reducing an induction component and preventing a surge due to resonance phenomena.

### <Second embodiment>

If the electrode 222 of the capacitor 22 is aligned with the conductive pattern of the power substrate 20, the electrode 222 and the conductive pattern can be directly connected. However, the present invention is not limited to this, and the electrode 222 of the capacitor 22 and the conductive pattern of the power substrate 20 can be connected via a lead wire. A second embodiment shows an example thereof. In the inverter device 10, the resin mold layer 12 is filled from the bottom of the module case 11, that is, the power substrate 20 to the lower surface of the control substrate 30, but the advantages of the present invention can be obtained if the resin mold layer 12 is filled to a position covering the capacitor 22.

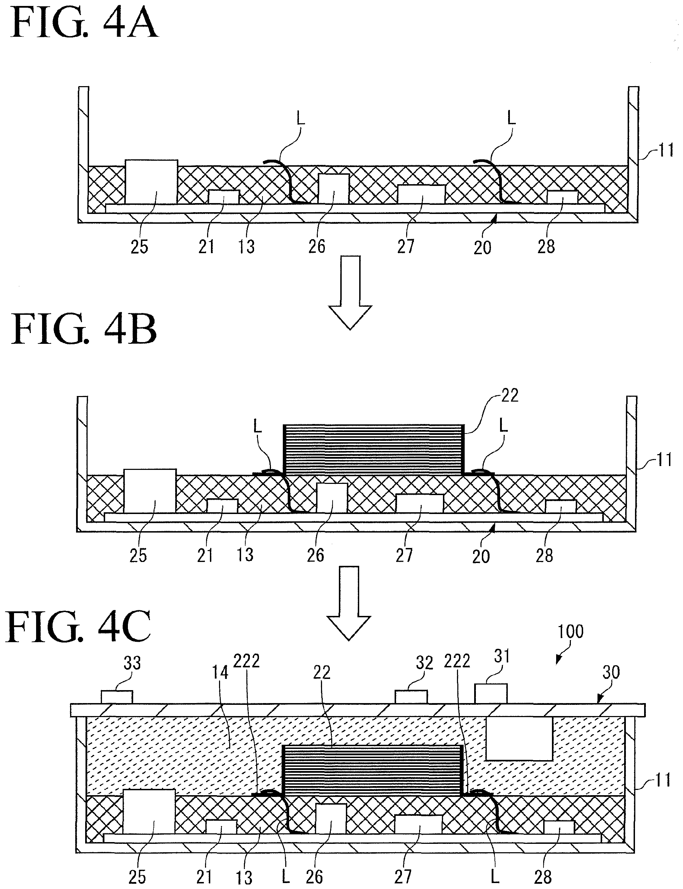

In the second embodiment, as shown in FIG. 4A, a first resin mold layer 13 is provided so that a lower end of a lead wire L is connected to a conductive pattern (not shown) and an upper end of the lead wire L is exposed from an upper surface of the first resin mold layer 13. At this time, the capacitor 22 is not yet placed in a predetermined position.

After the first resin mold layer 13 is cured, the capacitor 22 is placed in a position where the electrode 222 of the capacitor 22 and the lead wire L can be connected on the first resin mold layer 13, and the electrode 222 of the capacitor 22 and the lead wire L are connected (FIG. 4B).

Then, epoxy resin is further poured into the module case 11 and hardened to provide a second resin mold layer 14. The capacitor 22 is firmly fixed in the module case 11 by the second resin mold layer 14.

The inverter device 100 of the second embodiment provides the same advantages as in the first embodiment, and also provides an advantage described below. Specifically, the electrode 222 of the capacitor 22 and the conductive pattern are connected via the lead wire L, and thus the conductive pattern can be provided in any position. Thus, higher flexibility in circuit design of the power substrate 20 is provided as compared with the conductive pattern formed correspondingly to a mounting position of the electrode 222 of the capacitor 22.

### <Third embodiment>

To confirm whether a capacitor is not damaged during assembly of an inverter device, a withstand voltage test is conducted after the assembly of the inverter device is completed. In conducting the withstand voltage test, the capacitor covered with a resin mold layer needs to be electrically disconnected from a high voltage power supply, and after the withstand voltage test is finished, the capacitor needs to be electrically connected to the high voltage power supply. A third embodiment proposes a configuration for satisfying the needs.

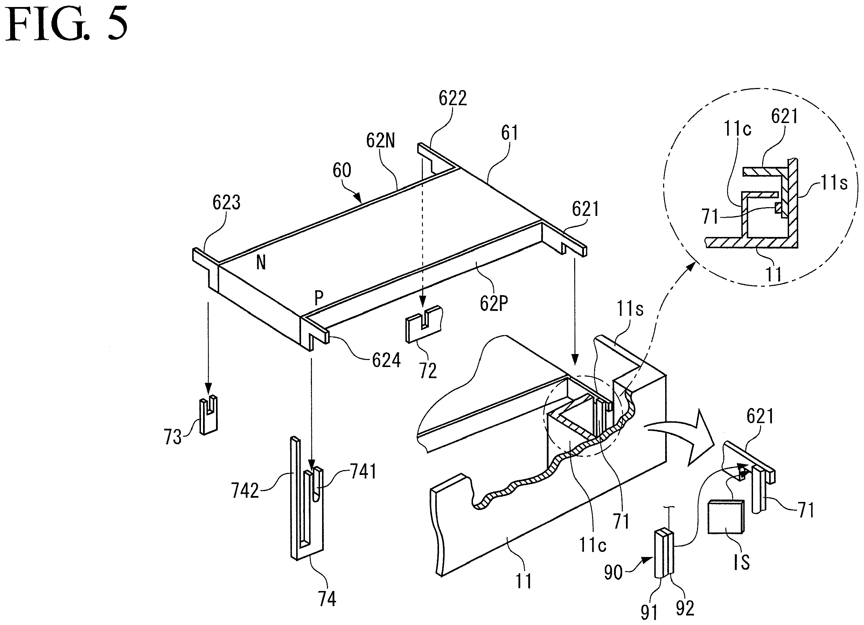

As shown in FIG. 5, a capacitor 60 according to the third embodiment includes electrodes 62P and 62N on opposite sides of a laminated body 61. The electrodes 62P and 62N have terminals 621 to 624 at opposite ends in a longitudinal direction bent outward into an L shape.

Support pins 71 to 74 corresponding to the terminals 621 to 624 are provided at four corners of a box-shaped module case 11 housing the capacitor 60.

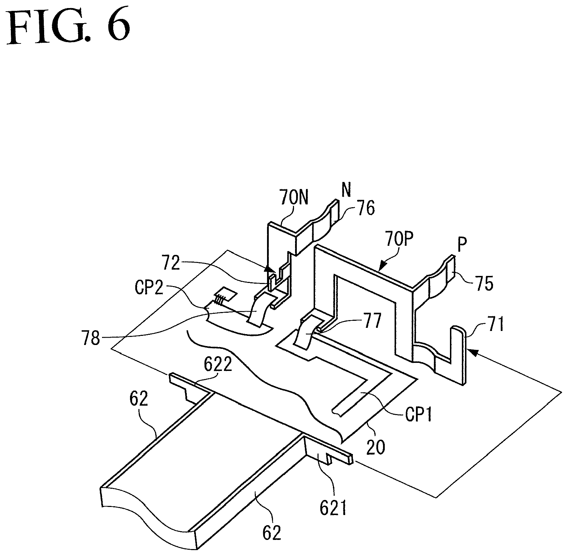

Among the support pins 71 to 74, the support pin 71 is a component of a busbar 70P including a terminal 75 electrically connected to the high voltage power supply, and a ribbon-shaped conductor 77 electrically connected to a conductive pattern CP1 of a power substrate 20 as shown in FIG. 6. Similarly, the support pin 72 is a component of a busbar 70N including a terminal 76 electrically connected to the high voltage power supply, and a ribbon-shaped conductor 78 electrically connected to a conductive pattern CP2 of the power substrate 20. The support pins 73 and 74 are members that mechanically support the capacitor 60 in an inverter device. However, the support pin 74 has a U-shaped support portion 741 that supports the terminal 624, and also a probe contact portion 742 with which a probe of a test device is brought into contact in a withstand voltage test.

A surrounding wall 11c having an L-shaped plane section surrounding the support pin 71 is formed around the support pin 71. The surrounding wall 11c is integrally formed with the module case 11. A gap is provided between a tip of the surrounding wall 11c and a side wall 11s of the module case 11, and through the gap, a tip of the terminal 621 of the capacitor 60 can be brought into contact with the support pin 71 in the surrounding wall 11c.

The terminals 621 to 624 are supported by the corresponding support pins 71 to 74, and the capacitor 60 is placed in a predetermined position in the module case 11. At this time, an insulating sheet IS is provided between the terminal 621 of the capacitor 60 and the support pin 71 to electrically disconnect the terminal 621 from the support pin 71, that is, disconnect the capacitor 60 from the high voltage power supply.

Then, resin such as epoxy is poured into the module case 11, and curing of a resin mold layer is waited for. The gap between the tip of the surrounding wall 11c and the side wall 11s of the module case 11 is narrow, and the terminal 621 of the capacitor 60 is inserted into the gap, thereby preventing the poured resin from entering inside the surrounding wall 11c. After the resin is cured, the probe of the test device is brought into contact with the probe contact portion 742 of the support pin 74, and a predetermined voltage is applied to conduct a withstand voltage test.

After the withstand voltage test is finished, the insulating sheet IS provided between the terminal 621 and the support pin 71 is removed. Since the resin does not enter inside the surrounding wall 11c, the insulating sheet IS can be easily removed.

As described above, according to the third embodiment, even for the inverter device in which the capacitor 60 is covered with the resin mold layer, a withstand voltage test can be easily conducted.

Instead of the insulating sheet IS, as shown in FIG. 5, a probe 90 including an insulator 91 placed on a side of the support pin 71 and a conductor 92 placed on a side of the terminal 621 may be provided between the terminal 621 of the capacitor 60 and the support pin 71, and the conductor 92 and the test device are connected, and then the probe 90 can function as a probe of the test device. In this case, the probe contact portion 742 of the support pin 74 is not needed.

### Description of Symbols

- 10, 100: inverter device
- 11: module case
- 12: resin mold layer
- 13: first resin mold layer
- 14: second resin mold layer
- 20: power substrate
- 21: switching element
- 22: capacitor
- 30: control substrate
- 40: high voltage power supply
- 50: electric motor
- 60: capacitor
- L: lead wire

## Claims

1. An inverter device (10) comprising:
a box-shaped module case (11) having an opening in an upper portion:
a power substrate (20) that is placed at a bottom in the module case (11), converts DC power supplied from a power supply (40) into AC power and applies the AC power to an electric motor (50);
a control substrate (30) that closes the opening in the module case (11) and controls the application of the AC power to the electric motor (50);
a smoothing capacitor (22) provided on the power substrate (20); and
a resin mold layer (12) that is provided in the module case (11) and filled from the power substrate (20) to at least a position covering the smoothing capacitor (22).

2. The inverter device (10) according to claim 1, wherein the smoothing capacitor (22) is comprised of a film capacitor element.

3. The inverter device (10) according to claim 1 or 2, wherein the smoothing capacitor (22) includes a laminated body (221) and an electrode (222) fixed to the laminated body (221), and
the electrode (222) and the power substrate (20) are electrically connected via a lead wire (L).

## Patentansprüche

1. Umrichtervorrichtung (10) mit:
einem kastenförmigen Modulgehäuse (11) mit einer Öffnung in einem oberen Abschnitt;
einem Leistungssubstrat (20), das an einem Boden in dem Modulgehäuse (11) angeordnet ist, Gleichstromleistung, die von einer Leistungszufuhr (40) zugeführt wird, in Wechselstromleistung wandelt und die Wechselstromleistung an einem elektrischen Motor (50) anlegt;
einem Steuersubstrat (30), das die Öffnung in dem Modulgehäuse (11) schließt und die Anwendung der Wechselstromleistung an dem elektrischen Motor (50) steuert;
einem Glättungskondensator (22), der auf dem Leistungssubstrat (20) vorgesehen ist;
einer Harzgussschicht (12), die in dem Modulgehäuse (11) vorgesehen ist und die von dem Leistungssubstrat (20) bis zumindest einer Position gefüllt ist, die den Glättungskondensator (22) bedeckt.

2. Umrichtervorrichtung (10), bei der der Glättungskondensator (22) ein Filmkondensatorelement umfasst.

3. Umrichtervorrichtung (10) nach Anspruch 1 oder 2, bei der der Glättungskondensator (22) einen beschichteten Körper (212) und eine Elektrode (222), die einen beschichteten Körper (212) angebracht ist, umfasst, und
wobei die Elektrode (222) und das Leistungssubstrat (20) elektrisch über einen Leitungsdraht (L) verbunden sind.

## Revendications

1. Dispositif onduleur (10) comprenant :
un coffret de module en forme de boîte (11) ayant une ouverture dans une portion supérieure;
un substrat d'alimentation (20) qui est placé au fond dans le coffret de module (11), convertit une alimentation continue fournie par une source d'alimentation (40) en alimentation alternative et applique l'alimentation alternative à un moteur électrique (50) ;
un substrat de commande (30) qui ferme l'ouverture dans le coffret de module (11) et commande l'application de l'alimentation alternative au moteur électrique (50) ;
un condensateur de lissage (22) installé sur le substrat d'alimentation (20) ; et
une couche de résine moulée (12) qui est disposée dans le coffret de module (11) et remplie depuis le substrat d'alimentation (20) vers au moins une position couvrant le condensateur de lissage (22).

2. Dispositif onduleur (10) selon la revendication 1, dans lequel le condensateur de lissage (22) est composé d'un élément de condensateur à film.

3. Dispositif onduleur (10) selon la revendication 1 ou 2, dans lequel le condensateur de lissage (22) comprend un corps stratifié (221) et une électrode (222) fixée au corps stratifié (221), et
l'électrode (222) et le substrat d'alimentation (20) sont électriquement connectés via un fil conducteur (L).
